# FASCICULE DE BREVET EUROPEEN

(11) **EP 2 178 032 B1**
(45) Date de publication et mention de la délivrance du brevet: **16.12.2015**
(21) Numéro de dépôt: 09172342.9
(22) Date de dépôt: 06.10.2009
(51) Int. Cl.: G06K 19/077

(54) **Module, carte à microcircuit et procédé de fabrication correspondant**
Modul, Mikrochipkarte und entsprechendes Herstellungsverfahren
Module, chip card and corresponding manufacturing method

(30) Priorité: 17.10.2008 FR 0857103
(43) Date de publication de la demande: 21.04.2010
(73) Titulaire: Oberthur Technologies, 92700 Colombes (FR)
(72) Inventeur: Bosquet, Olivier, 35370 Etrelles (FR); Barbotin, Aurélie, 35200 Rennes (FR)
(74) Mandataire: Esselin, Sophie

(56) Documents cités:
- EP-A- 1 724 712
- US-A1- 2002 089 049
- US-A1- 2005 045 729

## Description

### DOMAINE DE L'INVENTION

Le domaine de l'invention est celui des cartes à microcircuit, et en particulier des cartes à microcircuit dites à double interface.

De manière connue, et comme décrit par exemple dans la demande FR 2 861 201 de la demanderesse, une carte à microcircuit à double interface, ou duale, est une carte qui comprend des bornes de connexion enterrées dans l'épaisseur du corps de carte, typiquement, des bornes de connexion d'une antenne, permettant une utilisation de la carte avec une connexion avec ou sans contact. Ces bornes de connexion enterrées sont connectées à des plages internes d'un module encarté dans une cavité du corps de carte.

Un module d'une carte à microcircuit est un élément qui est fabriqué séparément du corps de carte, auquel il est assemblé dans une opération dite d'encartage. Il est généralement composé d'un film support dont une face comporte des plages de contact pour la connexion externe de la carte, à un lecteur de carte correspondant, et dont l'autre face supporte des plages de contact interne, qui sont connectées à des plots de connexion d'un circuit intégré fixé sur cette même face. De manière habituelle, s'agissant d'une carte duale, des plots du circuit intégré sont connectés à des plages de contact interne en continuité électrique avec des plages de contact externe du module ; d'autres plots du circuit intégrés sont connectés à d'autres plages de contact interne qui seront connectées, dans la cavité du corps de carte, à des bornes de connexion enterrées.

Le circuit intégré et ses connexions émergent de la face inférieure du module. Typiquement le circuit intégré a une épaisseur qui peut atteindre par exemple 150 microns. Dans le cas où le circuit intégré est relié aux plages de contact par des fils de connexion, il faut y ajouter l'épaisseur prise par ces fils partant des plots de contacts du circuit intégré, sur le dessus du circuit, pour aller sur les plages de contact interne du module. L'encartage d'un tel module nécessite donc la réalisation d'une cavité dans le corps de carte, avec une partie centrale plus profonde pour loger le circuit intégré et éventuellement ses connexions, et un rebord ou gradin sur lequel viennent se reposer les bords de la face interne du module.

Une telle cavité est généralement obtenue par usinage, typiquement par fraisage ou lamage, en deux opérations : un grand lamage, correspondant à la profondeur du gradin, puis un petit lamage pour atteindre la profondeur voulue dans la zone centrale. Typiquement la zone centrale a une profondeur de l'ordre de 610 microns, et la zone périphérique, une profondeur de l'ordre de 290 microns, pour recevoir un module dont l'épaisseur habituelle, hors circuit intégré, est de l'ordre de 210 microns.

Lorsque la carte à microcircuit, comprend un insert d'antenne dans son épaisseur, les bornes de connexion de l'antenne affleurent au niveau du gradin de la cavité, permettant leurs connexions avec des plages de contact interne du module, l'insert se trouvant sensiblement dans le milieu de l'épaisseur du corps de carte. Le terme sensiblement exprime le fait qu'en pratique, selon que l'insert est plus ou moins épais, l'insert peut être centré, ou légèrement décentré vers le haut, ou vers le bas.

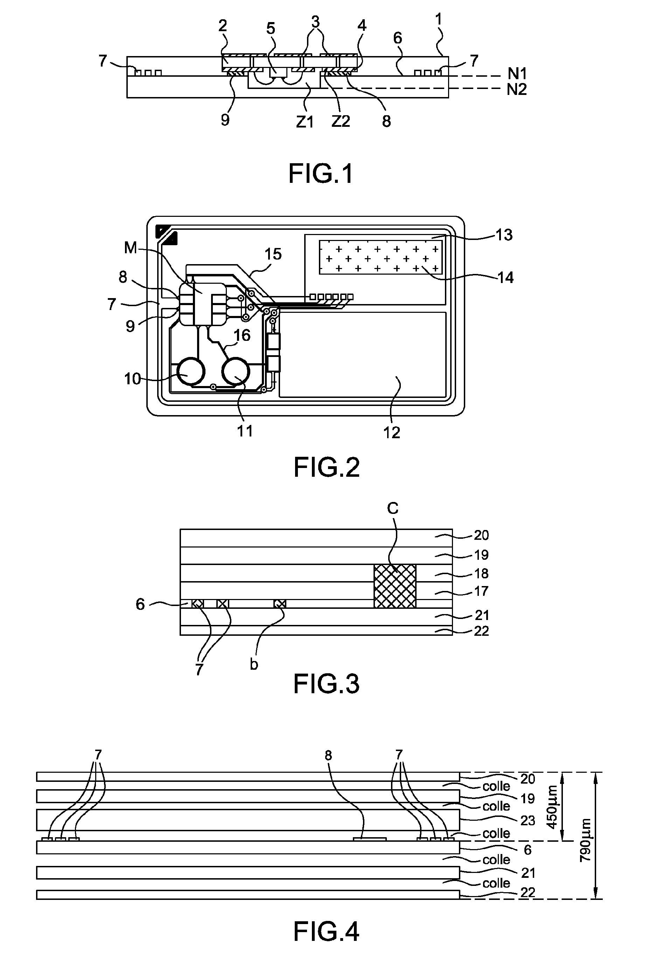

Une carte à microcircuit correspondante est illustrée sur la figure 1, montrant une portion du corps de carte 1 en coupe transversale. Le corps de carte a une épaisseur e sensiblement de l'ordre de 760 microns, suivant la norme ISO 7816 des cartes à microcircuit. Il comprend dans son épaisseur :
- une couche d'insert 6, ou inlay, qui porte une antenne 7, et des bornes de connexion 8 et 9 de cette antenne. Ce peut être un matériau non conducteur tel qu'une couche de plastique, de papier ou d'époxy, sur laquelle est déposée une antenne par toute technique connue (sérigraphie, gravure, insertion d'un fil).
- une cavité comprenant une zone périphérique z2 formant un gradin autour d'une zone centrale z1 plus profonde.
- un module à microcircuit 2 placé dans la cavité. Les plages de contact externe 3 en face supérieure du module affleurent en surface du corps de carte. Les plages de contact interne 4 en face inférieure du module reposent en partie sur le gradin z2 de la cavité, ce qui permet la connexion des bornes de connexion 8 et 9 de l'antenne affleurant dans la zone z2, à des plages de contact interne. La zone centrale z1 de la cavité loge le circuit intégré 5 et ses connexions aux parties des plages de contact interne qui se prolongent dans la zone centrale.

Avec l'utilisation de plus en plus répandue des cartes à microcircuit, il existe une demande pour une offre plus large de services.

Pour y répondre, on se propose d'intégrer d'autres composants/fonctionnalités dans le corps de carte.

On se propose notamment d'intégrer des composants sur l'insert. Par exemple, on se propose d'y placer un ou plusieurs éléments supplémentaires, en plus de l'antenne, tel qu'une batterie, un module d'affichage, des plots de boutons de contact, un capteur solaire, etc... La liste n'est pas limitative.

Un tel insert de composants est illustré à titre d'exemple sur la figure 2, en vue de dessus. L'insert 6 comporte en plus de l'antenne 7 et ses bornes de connexion 8 et 9, deux boutons 10 et 11, par exemple deux boutons mécaniques, une batterie 12, et un module 13 avec afficheur 14. L'alimentation ou la commande des éléments est assurée de manière appropriée au moyen de pistes conductrices prévues sur l'insert, telles les pistes 15 ou 16, qui relient ces éléments à des bornes de connexion qui sont distribuées au droit du gradin sur lequel viendront des plages de contact interne du module. De cette manière, les différents composants et l'antenne de l'insert peuvent être reliées au circuit intégré par des plages de contact interne du module encarté. C'est ce qui est schématiquement illustré sur la figure 2, par la représentation du module, par-dessus les différentes bornes de connexion des éléments. Le corps de carte sera formé avec un tel insert, de manière à ce que l'afficheur et la batterie soient enterrés dans le corps de carte. On prévoit le cas échéant la formation d'une fenêtre de visualisation au-dessus de l'afficheur. S'agissant des boutons mécaniques 10 et 11, on peut prévoir de former le corps de carte de manière à ce que ces boutons ressortent en face supérieure (moulage ou découpes adaptés du corps de carte). On peut aussi prévoir, en variante, que ces boutons soient enfouis dans le corps de carte, et repérés en surface par une personnalisation graphique adaptée, indiquant le lieu de pression permettant de les activer.

Cependant, l'intégration d'un tel insert de composants dans un corps de carte à microcircuit nécessite la prise en compte de l'épaisseur de ces éléments. Par exemple une batterie ou un afficheur peuvent avoir une épaisseur de l'ordre de 300 microns au moins. Dans l'état de l'art, l'insert est sensiblement au milieu du corps de carte. L'épaisseur de la partie du corps de carte au-dessus de l'insert est ainsi de l'ordre de 350 microns, l'épaisseur normalisée d'un corps de carte à microcircuit étant de 760 microns. Ainsi, avec un insert centré, l'épaisseur au dessus de cet insert sera généralement insuffisante à encapsuler les éléments ajoutés sur l'insert.

On est ainsi amené à modifier la conception du corps de carte de manière à permettre l'encapsulation d'éléments supplémentaires de l'insert, sans modifier substantiellement l'épaisseur du corps de carte, qui doit rester dans les tolérances permises pour permettre son utilisation avec les lecteurs de carte du commerce conformes à la norme ISO 7816.

Une solution pour permettre l'intégration d'éléments supplémentaires sur l'insert est de décentrer cet insert vers le fond du corps de carte, de manière à libérer une épaisseur suffisante au dessus de l'insert, pour encapsuler les éléments ajoutés.

Si on prend l'exemple d'un corps de carte obtenu par moulage plastique, on peut prévoir de réaliser un moulage plastique autour de l'insert tel que l'on ait un volume suffisant de matière au dessus de l'insert pour encapsuler les éléments supplémentaires du corps de carte, et plus important que le volume sous l'insert.

Si considère un corps de carte obtenu par empilement de couches, pour pouvoir intégrer l'épaisseur supplémentaire des composants ajoutés sur l'insert, on prévoit d'ajouter une ou des couches plastiques supplémentaires entre l'insert et la couche imprimée, avec une découpe ou une cavité correspondante à l'endroit des éléments ajoutés de l'insert.

En effet, il n'est pas possible d'intégrer cette épaisseur en utilisant les seules couches habituelles de l'empilement, car l'épaisseur de chacune des couches habituelles de l'empilement ne peut pas être modifiée dans de grandes proportions, sans répercussions sur l'outillage (tolérances) ou sur leurs fonctionnalités (rigidité). En particulier l'empilement comprend habituellement une couche imprimée et une couche de protection au dessus et en dessous de l'insert. Typiquement l'épaisseur d'une couche d'impression doit correspondre aux tolérances des outils d'impression habituellement utilisés. Et la couche de protection ne dépasse généralement pas 50 microns d'épaisseur.

La figure 3 illustre de manière schématique une vue en coupe transversale d'un exemple de corps de carte obtenu par empilement de couches, avec un insert 6 à antenne 7, qui porte en outre un élément C de plus grande épaisseur.

L'insert 6, fabriqué séparément, vient s'insérer entre les autres couches de l'empilement. La figure montre les boucles 7 d'antenne, une borne de connexion b, et le composant C. Dans l'exemple, on a par-dessus l'insert 6, dans cet ordre, une première couche intermédiaire 17 et une deuxième couche intermédiaire 18, qui permettent d'absorber l'épaisseur du composant C, puis une couche supérieure imprimée 19 et une couche finale de protection 20 (overlay). Dans l'exemple, les couches 17 et 18 sont opaques, et les deux couches supérieures 19 et 20 sont en matière transparente. Sous l'insert, on trouve de manière habituelle une couche inférieure 21, qui peut être imprimée et une couche de protection finale 22, dans l'exemple transparente. Les dimensions des couches sont choisies pour obtenir l'épaisseur nominale du corps de cartes.

Une autre manière d'ajouter des fonctionnalités supplémentaires dans une carte à microcircuit, est encore de prévoir l'insertion d'autres couches fonctionnelles, dans le corps de carte, au-dessus de l'insert. Une telle solution entraîne également le décentrage de l'insert vers le fond du corps de carte. La figure 4 illustre un exemple correspondant. Dans cet exemple, une couche fonctionnelle 23 est intégrée dans le corps de carte, au-dessus de l'insert 6. Dans l'exemple, l'insert 6 est classique, ne comportant qu'une antenne 7 et ses bornes de connexion 8 et 9. La couche 23 est dans l'exemple une couche métallique ou à aspect métallique, permettant de donner à la surface supérieure de la carte, un aspect métallique, au moins dans une fenêtre de visualisation. On peut encore prévoir une couche piézoélectrique.

Plus généralement, le corps de carte que l'on cherche à réaliser est un corps de carte dont l'insert est décentré vers le fond de la carte, et non plus sensiblement au milieu, soit qu'il comprend d'autres composants que l'antenne, plus épais que l'antenne, soit que le corps de carte comprend une ou des couches fonctionnelles au-dessus de l'insert, ou une combinaison de ces deux possibilités.

On comprend donc que l'augmentation des fonctionnalités d'une carte à microcircuit par ajout d'un insert de composants et/ou d'insert de couches fonctionnelles, entraine le décentrage de cet insert vers le fond de la carte, de manière à encapsuler de manière convenable les éléments ajoutés.

Ce faisant, les bornes de connexion de l'antenne se retrouvent sur un niveau plus profond du corps de carte.

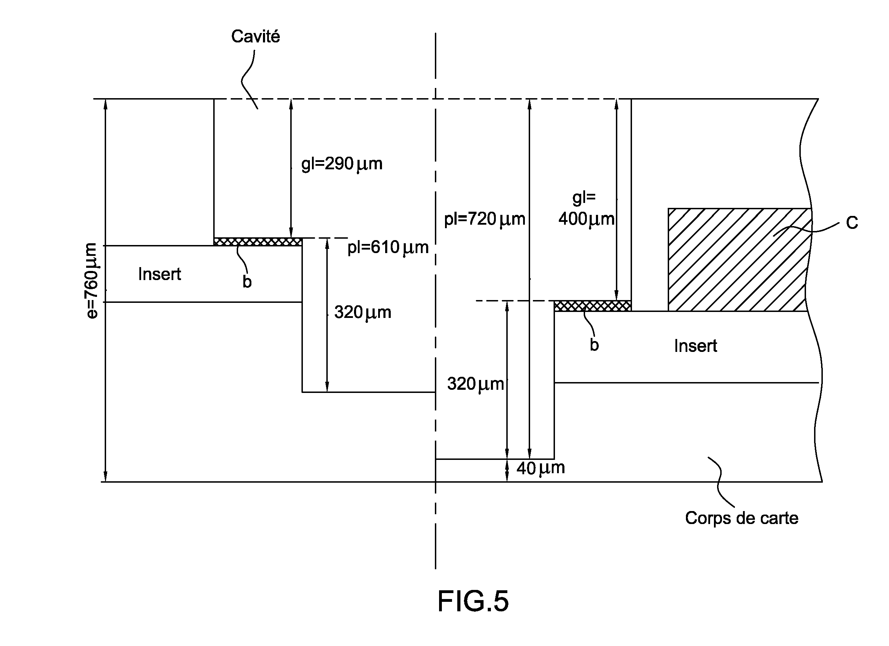

Ce problème est illustré sur la figure 5, qui montre les différents niveaux à considérer dans un corps de carte à microcircuit, d'épaisseur standard, nominale de 760 microns, suivant la norme ISO 7816.

La partie gauche de la figure illustre le cas où le corps de carte correspond à l'état de l'art, avec un insert sensiblement central. Dans l'exemple, la cavité réalisée pour placer le module à microcircuit, comprend un gradin à 290 microns (grand lamage gl) de la face supérieure du corps de carte, qui dégage les bornes de connexion 8,9 de l'insert 7, et une cavité centrale (petit lamage pl) de sensiblement 610 microns de profondeur. La différence entre le petit lamage et le grand lamage est ainsi de l'ordre de 320 microns, correspondant au volume nécessaire pour loger le circuit intégré du module et ses connexions.

La partie droite de la figure illustre le cas d'un corps de carte dissymétrique envisagé dans la présente invention. L'insert comprend dans l'exemple un composant C, dans l'exemple de 200 microns d'épaisseur. L'insert a été déporté vers le fond de la carte, pour permettre l'encapsulation de ce composant. Dans l'exemple les bornes de connexion de l'insert, c'est-à-dire les bornes de connexion de l'antenne et du composant, sont ainsi enterrées à 400 microns de profondeur de la face supérieure du corps de carte. La cavité réalisée pour placer le module à microcircuit, devrait alors comprendre un gradin à 400 microns (grand lamage gl), pour dégager les bornes de connexion sur l'insert. Il faut ensuite réaliser la cavité centrale (petit lamage pl) plus profonde, pour loger le circuit intégré du module et ses connexions. On doit alors réaliser un petit lamage de 320 microns, ce qui amène à une profondeur de 720 microns par rapport à la face supérieure du corps de carte. Le corps de carte ayant une épaisseur de 760 microns, le fond de la cavité devient trop mince, 40 microns dans l'exemple, ce qui fragilise le corps de carte à cet endroit de façon inacceptable.

Cela pose une limite maximale à l'épaisseur des composants que l'on pourrait ajouter, typiquement pas plus de 150 microns. En particulier un composant tel qu'une batterie ou un afficheur est plus épais, de l'ordre de 300 microns.

La technique d'encartage et de connexions à des bornes enterrées dans le corps de carte selon l'état de l'art connu n'est donc pas adaptée.

On connaît une autre technique d'encartage avec connexion à des bornes enterrées décrite dans la demande WO 99/06949, par laquelle les connexions aux bornes enterrées sont réalisées par le fond de la cavité sous le circuit intégré. Comme illustré sur la figure d'abrégé, cette technique nécessite d'utiliser une couche d'un adhésif conducteur dans le fond de la cavité, sous la résine de protection du circuit intégré du module et son fil de connexion à une plage de contact externe. La résine de protection dans la cavité délimite un espace entre la couche adhésive conductrice au fond de la cavité et le dessous d'une plage de contact en surface. Cet espace est rempli d'un matériau électriquement conducteur qui assure la connexion électrique entre l'extrémité de l'antenne et une plage de contact externe. Cette technique n'est pas plus adaptée à une connexion à des bornes enterrées sur un insert décentré. Notamment, le module (plages de contact externe + circuit intégré et ses fils de connexion) est très mince. Le procédé de remplissage de la cavité avec deux matériaux différents, par-dessus une couche adhésive conductrice n'est pas simple.

L'invention a pour objet de résoudre le problème technique d'encartage et de connexion d'un module de carte à microcircuit à des bornes enterrées posé par la réalisation d'un insert décentré dans un corps de carte à microcircuit.

Ce problème technique est résolu dans l'invention par l'intégration du circuit intégré dans l'épaisseur du module, au moyen d'une cavité réalisée dans le module sur la face par laquelle le module est encarté dans le corps de carte, en sorte que la cavité du corps de carte pour recevoir le module peut avoir une profondeur réduite dans la zone centrale, puisque le circuit intégré au moins est déjà pris dans l'épaisseur du module, au lieu d'émerger de la surface du module comme dans l'art antérieur.

La demande US2002/089049 concerne un module électronique notamment pour étiquettes électroniques, qui supporte le microcircuit, mais aussi une antenne. Dans un mode de réalisation où l'antenne est réalisée sur la même face de support que le microcircuit, le microcircuit est disposé dans une cavité ménagée dans le support du module.

L'invention concerne donc un module de carte à microcircuit destiné à être encarté dans un corps de carte à insert(s), comportant un support, des plages de contact externe sur une face supérieure du support, et des plages de contact interne sur une face inférieure du support qui sont destinées à venir en contact électrique sur des bornes de connexion d'insert(s) du corps de carte, et un circuit intégré sur la face inférieure, caractérisé en ce que ledit circuit intégré est logé dans l'épaisseur du support, dans une cavité ouverte sur ladite face inférieure, les plages de contact interne étant disposées en périphérie de ladite cavité et la profondeur de ladite cavité étant sensiblement égale ou supérieure à l'épaisseur dudit circuit intégré.

Selon un mode de réalisation du module, le support est avantageusement réalisé d'une seule pièce. La cavité pour loger le microcircuit est facilement usinée sur une des faces et permet d'y loger un circuit intégré épais.

Selon un autre mode de réalisation du module, le support est constitué de deux supports contrecollés, un support supérieur portant sur une face les plages de contact externe, un support inférieur portant sur une face les plages de contact interne, et la cavité pour le circuit intégré étant obtenue par découpe du support inférieur. Ce mode de réalisation a comme avantage de permettre le choix de l'épaisseur du support inférieur en fonction de l'épaisseur du circuit intégré du module. Avantageusement, en prenant un support inférieur d'épaisseur correspondant à la profondeur de la cavité à réaliser, la cavité peut être formée par estampage du support inférieur avant contre-collage sur le premier support.

Dans ces deux modes de réalisation, la profondeur de cavité correspond sensiblement à l'épaisseur du circuit intégré. Le circuit intégré est connecté aux plages de contact interne par des fils de connexion. Seuls ces fils de connexion émergent de la surface inférieure du module. Le volume nécessaire à prévoir pour l'encartage de cette partie du module est bien plus réduit que dans l'art antérieur où le circuit intégré et ses connexions émergent de la surface inférieure du module.

Selon un autre mode de réalisation de l'invention, des plages de contact formant un niveau de connexion intermédiaire sont réalisées entre les deux supports, et le circuit intégré est connecté sur ce niveau de connexion intermédiaire, soit par montage flip chip, avec les plots du circuit intégré directement fixés sur ces plages de contact intermédiaire, soit par des fils de connexion partant des plots sur ces plages de connexion intermédiaire. Dans les deux cas, le circuit intégré et ses connexions sont complètement logés dans la cavité. On peut alors réaliser l'enrobage du circuit intégré et ses connexions dans le module lui-même, avant l'encartage, par un matériau de protection emplissant la cavité. Le circuit intégré est alors avantageusement protégé par cet enrobage, pour les tests qui sont habituellement réalisés sur le module, et les manipulations avant encartage. Le module se présente alors sous la forme d'un objet sensiblement d'égale épaisseur. Cette forme a pour avantage que la cavité du corps de carte pour encarter ce module peut être d'égale profondeur sur toute sa surface. En particulier un seul lamage est nécessaire pour la réaliser.

Tous les modes de réalisation d'un module selon l'invention utilisent les équipements habituels de production et d'encartage des modules.

L'invention concerne une carte à microcircuit comprenant un module selon l'invention, et notamment une carte à microcircuit dont le corps de carte comprend un ou des inserts, en particulier un insert d'antenne.

L'invention concerne aussi un procédé de fabrication d'une carte à microcircuit correspondant.

D'autres avantages et caractéristiques de l'invention sont détaillés dans la description suivante, et en référence aux dessins annexés dans lesquels :
- la figure 1 illustre une carte à microcircuit à double interface, selon l'état de l'art ;
- la figure 2 illustre un exemple d'insert à antenne et composants supplémentaires ;
- la figure 3 illustre un empilement de couches autour d'un tel insert pour former un corps de carte correspondant ;
- la figure 4 illustre un autre exemple d'empilement de couches dans un corps de carte intégrant un insert avec antenne, et un insert d'une couche fonctionnelle au-dessus ;
- la figure 5 est un schéma en coupe illustrant le déport de l'insert vers le fond du corps de carte ;
- la figure 6 montre en coupe transversale, un module selon un premier mode de réalisation de l'invention ;
- la figure 7 montre en coupe transversale, l'encartage d'un tel module dans un corps de carte ; et
- les figures 8 à 14, illustrent des étapes de fabrication d'un tel module ;
- la figure 15 montre en coupe transversale, un module selon un deuxième mode de réalisation de l'invention ;
- la figure 16 montre en coupe transversale, l'encartage d'un tel module dans un corps de carte ; et
- les figures 17 à 23, illustrent des étapes de fabrication d'un tel module ;
- la figure 24 montre en coupe transversale, un module selon un troisième mode de réalisation de l'invention ;
- la figure 25 montre en coupe transversale, l'encartage d'un tel module dans un corps de carte ;
- les figures 26 et 27 illustrent une variante des figures 24 et 25, dans laquelle le montage et la connexion du circuit intégré est du type flip-chip ; et
- les figures 28 à 35, illustrent des étapes de fabrication d'un tel module.

Un module pour un corps de carte à insert décentré vers le fond, c'est-à-dire se situant à une profondeur supérieure à la moitié de l'épaisseur totale du corps de carte, comprend, selon l'invention, une cavité sur sa face interne, c'est-à-dire celle qui porte les plages de contact interne et qui est la face par laquelle le module est introduit dans une cavité correspondante du corps de carte, au moment de l'encartage. Le circuit intégré du module est fixé dans cette cavité. Il peut être connecté à des plages de connexion du module par des fils de connexion ou directement par ses plots (montage flip-chip), selon les modes de réalisation envisagés, comme détaillé dans la suite de la description.

Le module obtenu est épais, d'épaisseur supérieure à la moitié de l'épaisseur normalisée d'une carte à microcircuit. Cette épaisseur s'entend entre les plages de contact interne et externe, plages comprises. Il est épais, par comparaison aux modules de l'état de l'art, sur lesquels le circuit intégré est fixé à la surface du module, sur la même face que les plages de contact interne. La réalisation d'un module épais selon l'invention, à cavité logeant au moins le circuit intégré du module, permet de réduire la profondeur de la cavité à réaliser dans le corps de carte pour encarter un tel module. Elle permet ainsi la réalisation de manière fiable de cartes à microcircuits à fonctionnalités élargies, par intégration de composants et/ou de couches fonctionnelles supplémentaires dans le corps de carte. La réalisation d'un tel module et d'une telle carte a en outre l'avantage d'utiliser les opérations et outillages standards, de fabrication des cartes à microcircuit. Elle est ainsi peu coûteuse.

Le module selon l'invention est ainsi particulièrement adapté à la réalisation de carte à microcircuit comprenant au moins un insert dans le corps de carte qui amène des fonctionnalités supplémentaires. Un insert peut être un insert qui comporte au moins un composant et des bornes de connexion de ce composant. Ces bornes de connexion sont alors connectées à des plages de contact interne du module encarté. L'insert peut comprendre une antenne, et/ou au moins un composant, notamment un ou des composants parmi les composants suivants : boutons, afficheur, batterie, capteur solaire, cellule biométrique (figure 2). Un insert peut aussi être une couche fonctionnelle, telle qu'une couche métallique, ou une couche piézoélectrique (figure 3). Le corps de carte peut comprendre plusieurs inserts, notamment un insert à composant(s) et un insert de couche fonctionnelle.

Différents modes de réalisation d'un module selon l'invention, et son encartage dans un corps de carte à microcircuit, vont maintenant être décrits.

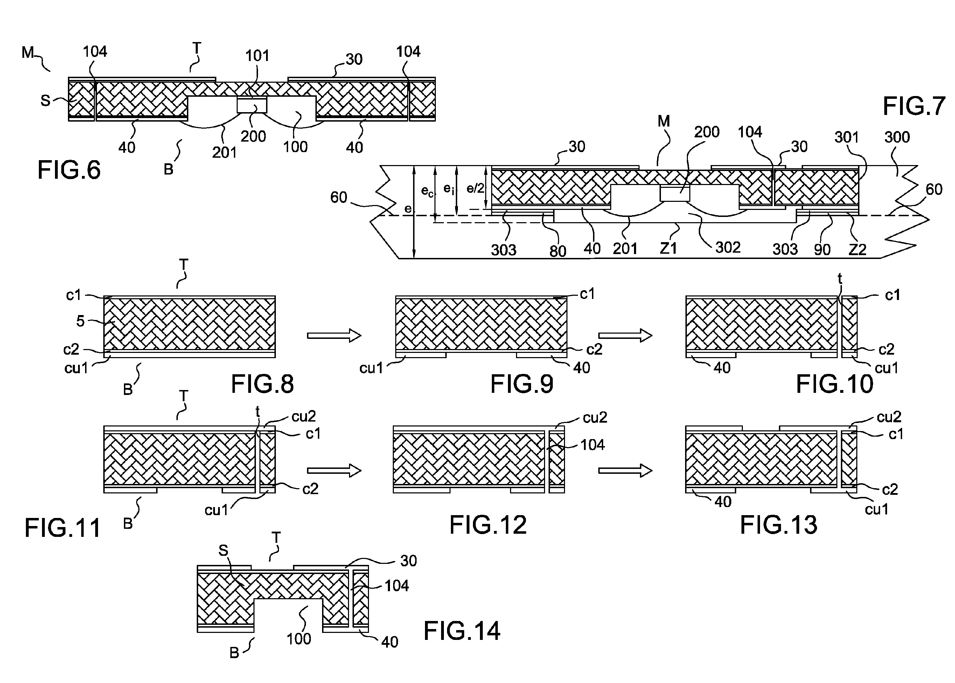

Un premier mode de réalisation est illustré sur la figure 6. Le module M comprend un support S, par exemple une couche d'époxy flexible, supportant sur une face supérieure T les plages de contact externe 30, et sur une face inférieure B, les plages de contact interne 40.

Une cavité 100 est ménagée dans l'épaisseur du support S, depuis la face inférieure B. Le circuit intégré 200 du module est fixé dans cette cavité. La fixation se fait par exemple au moyen d'une colle adaptée 101, désignée habituellement par l'expression *« die attach* » (fixation de substrat).

Le circuit intégré 200 est connecté à des plages de contact interne 40 du module par des fils de connexion 201 partant de ses plots de contact.

Il est utile de rappeler qu'habituellement, dans une carte à microcircuit à double interface (carte duale), certains contacts du circuit intégré sont connectés à des contacts internes en continuité électrique avec des plages de contact externe, et d'autres contacts du circuit intégré sont connectés à d'autres plages de contact interne qui sont connectées aux bornes de connexion enterrées. Dans ce contexte, et comme représenté sur la figure 6 ou 7, des trous borgnes métallisés 104 sont réalisés dans l'épaisseur du support pour chacune des plages de contact interne qui doit être en continuité électrique avec des plages de contact externe.

Des étapes de fabrication d'un module correspondant sont illustrées sur les figures 8 à 14.

On part d'un support S, par exemple en époxy.

Une couche de colle c1 est déposée sur sa face supérieure T et une couche de colle c2 est déposée sur sa face inférieure B. Puis une couche de cuivre cu1 est contrecollée sur la face inférieure B, sur la couche c2 (Fig.8). Cette couche de cuivre cu1 est gravée (Fig.9), formant les plages de contact 40, puis des trous débouchants t sont percés depuis la surface de colle c1 de la face supérieure T, jusqu'à la surface de plages de contact interne déterminées 40 (Fig.10).

Une couche de cuivre cu2 est contrecollée sur la couche de colle c1 en face supérieure T (Fig.11), ce qui recouvre les trous t en face supérieure, et permet leur métallisation, typiquement par électrolyse (Fig.12) : on obtient ainsi les vias 104 du module c'est à dire des trous borgnes métallisés. Ensuite, cette couche de cuivre cu2 est gravée pour former les plages de contact externe 30.

La cavité 100 est ensuite usinée sur la face inférieure B (Figure 14). La profondeur de la cavité est au moins sensiblement égale, ou supérieure à l'épaisseur du circuit intégré 200, en sorte que le circuit intégré est logé dans l'épaisseur du support. De préférence, la profondeur de la cavité est sensiblement égale à l'épaisseur du circuit intégré 200, en sorte que la surface du circuit intégré qui porte ses plots de contact, soit sensiblement au même niveau que les plages de contact interne en périphérie de la cavité. On entend par profondeur de la cavité, la profondeur de la cavité relativement à la surface des plages de contact. Cela correspond ici typiquement à la profondeur d'usinage dans le support, augmenté de l'épaisseur de la couche de colle c2 (typiquement 10 à 20 microns) et de cuivre cu1 (typiquement 35 microns).

La cavité 100 formée, il reste à y fixer le circuit intégré et à réaliser ses connexions, pour obtenir le module M de la figure 6.

Le module M est alors prêt à être encarté dans un corps de carte 300. De sa face inférieure par laquelle il doit être encarté, dépassent seulement les fils de connexion.

La figure 7 illustre l'exemple l'encartage d'un module ainsi obtenu, dans un corps de carte comprenant un insert 60 décentré, c'est-à-dire situé dans la moitié inférieure de l'épaisseur du corps de carte : l'insert 60 est ainsi à une profondeur eᵢ supérieure à la moitié de l'épaisseur e du corps de carte. Cet insert comporte notamment des bornes de connexion 80, 90 prévues pour être connectées à des plages de contact interne d'un module.

Dans l'exemple, la cavité du module est plus profonde que l'épaisseur du circuit intégré qui y est logé.

Le corps de carte est usiné pour y former en face supérieure, une cavité 301, avec un grand lamage à une première profondeur, pour former le gradin z2 sur lequel va reposer le bord de la face interne du module, puis un petit lamage pour former une zone centrale z1 un plus profonde, juste assez profonde pour loger les fils de connexion du module. Les bornes de connexion 80, 90 de l'insert 60, sont dégagées en surface du gradin z2 de la cavité.

La différence de profondeur entre le gradin z2 et la cavité centrale z1 est faible, par exemple de l'ordre de 180 microns. La profondeur e_{c} de la cavité dans sa zone centrale z1 arrive ainsi sous le niveau de cet insert 60, mais suffisamment loin du fond du corps de carte.

Le module M est encarté dans cette cavité 301. Typiquement un matériau d'enrobage 302 est déposé dans la zone centrale de la cavité 301 du corps de carte et un adhésif conducteur anisotrope303 est déposé au fond du gradin, puis le module est encarté. Un tel encartage correspond à une opération d'encartage tout à fait classique. On remarquera que le matériau d'enrobage 302 injecté lors de l'encartage est prévu pour remplir la cavité 100 du module M et la cavité 301 du corps de carte.

A titre d'illustration, on donne différentes dimensions du module et de la carte qui peuvent être obtenues : épaisseur totale du module mesurée entre les deux surfaces de cuivre cu1 et cu2 (plages de cuivre comprises), de l'ordre de 410 µm ; épaisseur du support S du module : 300 µm ; profondeur de la cavité : 150 µm, pour un circuit intégré d'épaisseur de l'ordre de 150 µm ou moins.

La profondeur e_{c} de la cavité 301 dans la zone z1 du corps de carte, correspondant au petit lamage, est de l'ordre de 680 µm. Le gradin (grand lamage) se situe sensiblement à une profondeur de l'ordre de 500 µm.

En plus des avantages de l'invention, à savoir l'utilisation des équipements de production standard pour réaliser le module M, les avantages supplémentaires du module selon ce premier mode de réalisation sont l'utilisation d'une seule couche de support, dont l'usinage de la cavité est facile à réaliser, utilisant les techniques habituelles, et permet de réaliser une cavité suffisamment profonde, adaptée à l'épaisseur des circuits intégrés à y loger.

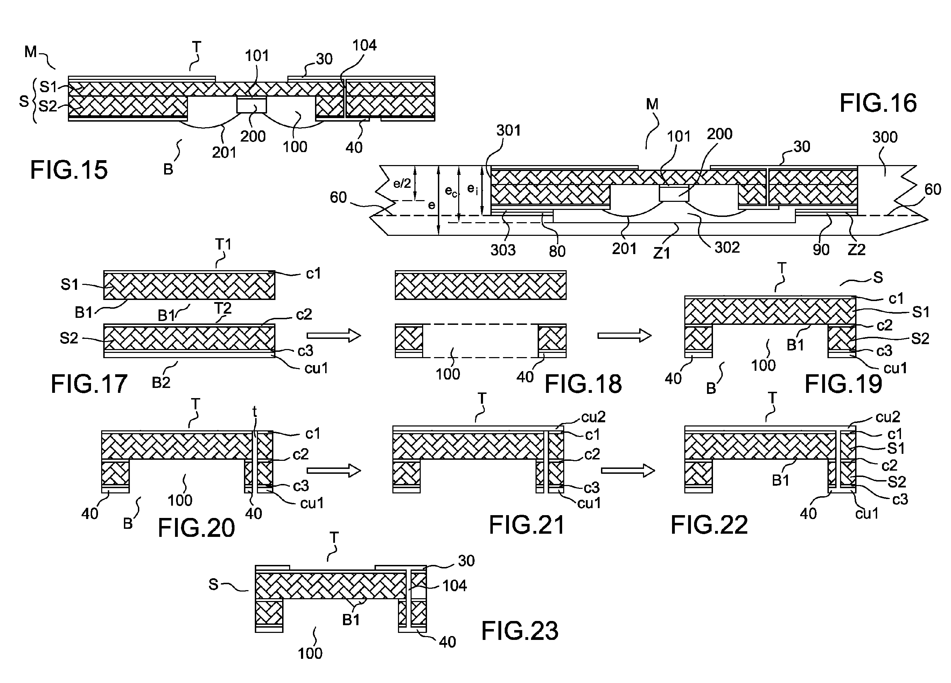

Un deuxième mode de réalisation d'un module selon l'invention est illustré sur la figure 15. Le module M comprend un support S, formé d'un support supérieur, qui porte les plages de contact externe 30 en face supérieure T du module, et d'un support S2 qui porte les plages de contact interne 40 une face inférieure B du module. Ce sont dans l'exemple chacun une couche d'époxy, assemblées par collage.

Pour les plages de contact interne 40 et externe 30 qui doivent être électriquement reliées, des trous borgnes métallisés 104 sont réalisés dans l'épaisseur du support S.

La cavité 100 est ménagée dans l'épaisseur du support inférieur S2. Le circuit intégré 200 du module est fixé au fond de cette cavité, sur la face interne du support supérieur S1. La fixation se fait au moyen d'une colle adaptée 101, désignée habituellement par l'expression « *die attach* » (fixation de substrat).

Le circuit intégré 200 est connecté à des plages de contact interne 40 du module par des fils de connexion 201 partant de ses plots de contact.

Ce module se distingue principalement en ce qu'il est réalisé à partir de deux supports contrecollés, la cavité étant réalisée par découpe dans l'épaisseur du support S2 avant d'être contrecollé au support S1. La profondeur de la cavité est essentiellement donnée par l'épaisseur du support S2 qui est au moins sensiblement égale ou supérieure à l'épaisseur du circuit intégré en sorte que le circuit intégré est logé dans l'épaisseur du support S2. De préférence, l'épaisseur du support S2, et donc de la cavité, esttelle que la surface du circuit intégré opposée à celle qui est fixée au fond de la cavité, est sensiblement au même niveau que lesdites plages de contact interne.

Des étapes de fabrication correspondantes sont illustrées sur les figures 17 à 23.

On part de deux supports S1 et S2, dans l'exemple chacun en époxy. Ces deux supports sont préparés séparément avant d'être contrecollés, de la façon suivante :
- pour le support S1, une couche de colle c1 est déposée sur une face supérieure T1 du support S1.
- pour le support S2, une couche de colle c2 est déposée sur une face supérieure T2 du support S2, et une couche de colle c3, est déposée sur sa face inférieure B2. Puis une couche de cuivre cu1 est contrecollée sur la face inférieure B2, sur la couche c3 (Fig.17). Le support S2 est ensuite découpé sur toute son épaisseur pour former les parois internes de la future cavité 100 (figure 18). Les plages de contact interne 40 sont formées par la découpe. La profondeur de la cavité est sensiblement égale à l'épaisseur du support S2. En fait, il faut aussi tenir compte de l'épaisseur des couches c2, c3 de colle (typiquement entre 10 et 20 microns) et de cuivre cu1, typiquement de l'ordre de 35 microns.

Les deux supports sont alors contrecollés, la face inférieure B1 du support S1 contre la face supérieure du support S2 : Le support S du module est ainsi formé avec sa cavité 100. Sa face supérieure T correspond à la face supérieure T1 du support S1, et sa face inférieure B correspond à la face inférieure B2 du support S2 (Fig.19).

Des trous débouchants t sont percés depuis la surface de colle c1 de la face supérieure T, jusqu'à la surface de cuivre cu1 sur la face inférieure (Fig.20), aux endroits désirés, pour permettre la continuité électrique entre les plages de contact externe et interne correspondantes qui doivent être connectées entre elles, permettant la connexion de plots du circuit intégré à des plages de contact externe du module, via les plages de contact interne et ces vias 104. Le motif de la couche de cuivre cu1 est obtenu successivement par découpe du support S2 (Fig.18), perçage des trous t (Fig.20) puis gravure, pour former les plages de contact interne 40 du module illustré sur la figure 15.

Une couche de cuivre cu2 est ensuite contrecollée sur la couche de colle c1 en face supérieure T (Fig.21), ce qui recouvre les trous t en face supérieure, et permet leur métallisation (Fig.22) : on obtient ainsi les vias 104 du module c'est à dire des trous borgnes métallisés. Ensuite, cette couche de cuivre cu2 est gravée pour former les plages de contact externe 30 (Fig.23).

Il reste à fixer le circuit intégré 200 dans la cavité 100, c'est-à-dire sur la face inférieure B1 du support S1, et à réaliser ses connexions 201 aux plages de contact interne 40, pour obtenir le module M de la figure 15.

Le module M est alors prêt à être encarté dans un corps de carte 300, comme illustré sur la figure 16. La formation du corps de carte avec la cavité pour encarter le module M est identique à celle décrite en relation avec la figure 7 (les éléments sont identifiés avec les mêmes références sur les figures 7 et 16).

Dans un exemple numérique, donné à titre d'illustration, on a un module M correspondant avec une épaisseur totale du module mesurée entre les deux surfaces de cuivre cu1 et cu2, cuivre compris, de l'ordre de 410 µm ; un support S1 de 150 microns d'épaisseur, un support S2 de 150 µm d'épaisseur, avec une cavité de profondeur correspondante obtenue par estampage, et un circuit intégré de 150 µm d'épaisseur ou moins. La profondeur e_{c} de la cavité 301 dans la zone z1, pour encarter ce module est de l'ordre de 680 µm.

En plus des avantages déjà cités, les avantages supplémentaires du module selon ce deuxième mode de réalisation sont la possibilité d'adapter le support inférieur à l'épaisseur du circuit intégré qui peut être plus ou moins épais selon le type de carte à microcircuit envisagé, le support supérieur pouvant être d'épaisseur toujours égale quel que soit le type de carte, et la possibilité de réalisation de la cavité par estampage, et non par usinage.

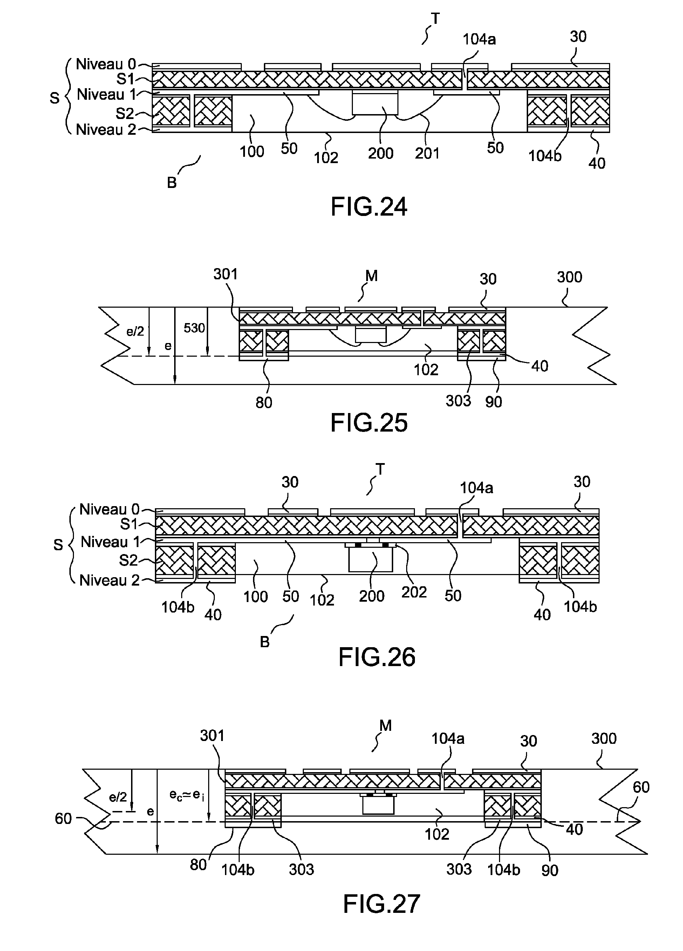

Un troisième mode de réalisation d'un module selon l'invention est illustré sur la figure 24. Dans ce troisième mode de réalisation, on a deux supports comme précédemment, mais qui définissent trois niveaux de connexion 0, 1 et 2, correspondant à trois couches de cuivre. Le niveau 0 correspond aux plages de contact externe 30. Le niveau 2 correspond aux plages de contact interne 40. Le niveau 1 est un niveau intermédiaire, à l'interface entre les deux supports S1 et S2, qui permet la connexion du circuit intégré 200 sur ce niveau, sur des plages de contact correspondantes 50. La profondeur de la cavité est prévue pour englober le circuit intégré et ses connexions, en sorte qu'il est possible d'enrober le circuit intégré 200 et ses connexion en dernière étape de fabrication du module M, avant son encartage. C'est ce que représente la référence 102 sur la figure.

Les connexions peuvent être réalisées par des fils 201 entre les plots de contact du circuit intégré et des plages de contact intermédiaire.

Dans une variante, comme représenté sur la figure 26, le circuit intégré est fixé et connecté selon un montage flip chip, c'est-à-dire en fixant ce circuit intégré au fond de la cavité par la face portant ses plots 202, les plages de contact intermédiaire 50 auxquelles le circuit intégré est connecté étant formées en sorte de se prolonger jusque sous chacun de ces plots 202.

Dans ce troisième mode de réalisation, on a des plages de contact externe en continuité électrique avec des plages de contact intermédiaire par des vias 104a à travers le support supérieur S1, pour la connexion de plots du circuit intégré à ces plages de contact externe ; et des plages de contact interne en continuité électrique avec des plages de contact intermédiaire par des vias 104b à travers le support inférieur S2, pour la connexion d'autres plots du circuit intégré à des plages de contact interne, qui seront connectées dans le corps de carte, typiquement par contact adhésif conducteur, à des bornes de connexion enterrées 80, 90.

On a ainsi dans le module :
- des vias 104a qui s'étendent dans le support S1 entre des plages de contact externe 30 et des plages de contact intermédiaire 50. Ces vias 104a sont typiquement en partie centrale du module, correspondant à la zone de connexion des plots du circuit intégré ; et
- des vias 104b, en périphérie, qui s'étendent entre des plages de contact interne 40 et des plages de contact intermédiaire 50, et qui permettent la connexion de plots du circuit intégré à des bornes de connexion enterrées 80, 90 dans un corps de carte 300, comme illustré sur les figures 25 et 26.

Dans une variante non représentée, on pourrait aussi prévoir des vias métallisés qui contactent les trois niveaux, c'est-à-dire qui s'étendent entre des plages externes et des plages internes. Une telle variante peut permettre à un dispositif extérieur, typiquement un lecteur, de communiquer directement avec un composant de l'insert, sans passer par le circuit intégré. Dans ce cas, les plages de contact correspondantes sur le niveau intermédiaire ne sont pas connectées au circuit intégré.

Le procédé de fabrication d'un tel module va différer du procédé précédent, essentiellement dans la préparation séparée des supports supérieur S1 et inférieur S2, pour réaliser les plages de contact gravées 50, et dans l'opération de perçage des vias 104a dans le premier support et des vias 104b dans le deuxième support.

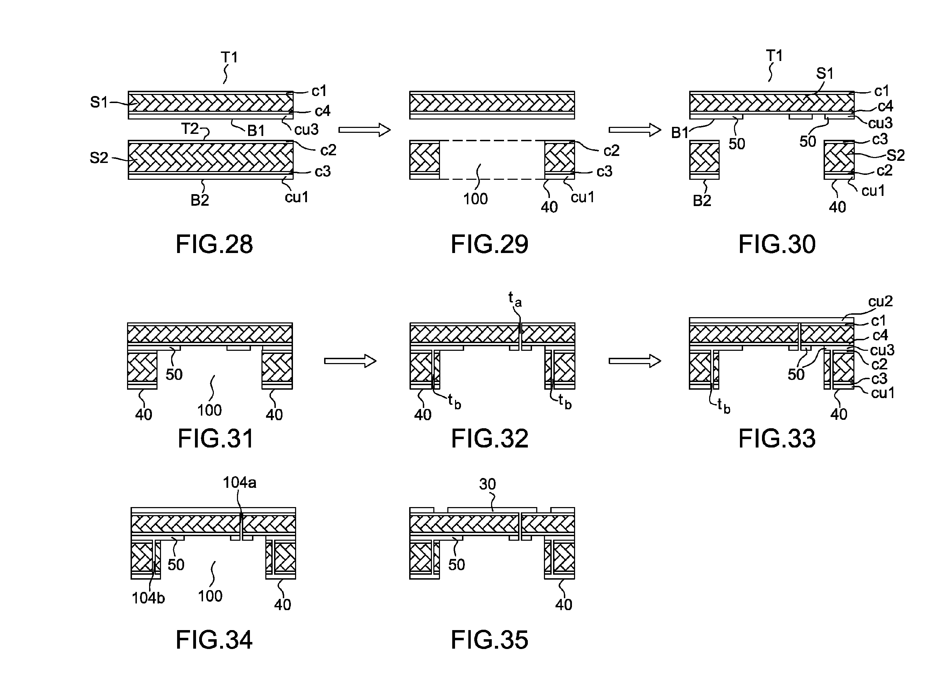

Dans l'exemple, une couche de colle c4 et une couche de cuivre cu3 sont contrecollées sur la face inférieure B1 du support supérieur (Fig. 28), qui seront gravées dans une phase ultérieure (Fig. 30). Le support S2 est préparé de la même manière que dans le deuxième mode de réalisation (Figs. 28 et 29). Les deux supports sont assemblés l'un à l'autre par la face inférieure B1 du support S1 et par la face supérieure T2 du support S2 (Fig.31). Des trous tₐ sont percés depuis la surface de la couche de colle c1 jusqu'à la surface des plages de contact intermédiaire 50, et des trous t_{b} sont percés depuis la surface de la couche de colle c1 jusqu'à la surface des plages de contact interne 40 (Fig. 32).

On retrouve ensuite les mêmes étapes que précédemment : contre collage de la couche de cuivre cu2 sur la face supérieure T (Fig.33), métallisation des trous, formant les vias métallisés 104a et 104b (Fig.34) et gravure des couches de cuivre cu1 et cu2 pour y former les plages de contact interne 40 et externe 30 (Fig. 35).

Il reste à monter le circuit intégré soit comme illustré sur la figure 24, avec fils de connexion, soit comme illustré sur la figure 26, en montage flip-chip.

Dans une dernière étape, on prévoit avantageusement de recouvrir le circuit intégré et ses connexions d'un matériau d'enrobage 102, qui remplit la cavité 100, plutôt que de réaliser cet enrobage au moment de l'encartage. Le circuit intégré est ainsi avantageusement protégé des agressions externes, notamment lors des tests ou manipulations avant encartage.

Le module M est prêt à être encarté. Il se présente sous la forme d'un objet d'égale épaisseur. Il est ainsi potentiellement moins épais que dans les deux modes de réalisation précédents, puisque rien n'émerge de la cavité.

Dans un exemple de réalisation, le module à une épaisseur totale de l'ordre de 410 µm, mesurée entre les surfaces des plages de contact externe et interne (plages comprises), une épaisseur du support supérieur S1 de l'ordre de 120 µm, celle du support inférieure S2 de l'ordre de 200 µm. La profondeur de la cavité 100 est égale à cette épaisseur, 200 µm.

Les figures 25 et 27 illustrent cet encartage pour les deux variantes de montage. En fait, l'opération d'encartage est la même dans les deux cas : elle nécessite l'usinage d'une cavité 300, qui est d'une seule profondeur sur toute sa surface, et qui dégage en périphérie les bornes de connexion enterrées 80 et 90.

Comme précédemment, ces bornes de connexion 80, 90 sont situées sur un insert 60 situé à une profondeur eᵢ depuis la surface du corps de carte portant les plages de contact externe 30, supérieure à la moitié de l'épaisseur e du corps de carte. Dans ce mode de réalisation, cette profondeur eᵢ correspond à la profondeur e_{c} de la cavité 300 usinée dans le corps de carte. Dans l'exemple, elle de l'ordre de 500 µm environ.

Les avantages supplémentaires de ce mode de réalisation sont qu'il ne nécessite plus qu'un seul lamage du corps de carte, au lieu de deux habituellement (grand et petit lamage), et un enrobage du circuit intégré et ses connexions avant encartage, ce qui renforce sa protection contre des pollutions éventuelles.

Dans tous les modes de réalisation représentés, il peut y avoir comme bornes de connexion enterrées 80, 90, des bornes de connexion d'une antenne, et/ou des bornes de connexion d'un ou plusieurs composants réalisés sur le même insert 60.

L'invention permet de réaliser de manière fiable et peu coûteuse, des cartes à microcircuit à insert de composants et ou insert de couches fonctionnelles, permettant d'élargir l'offre de service de ces cartes, par des fonctionnalités supplémentaires, en utilisant les étapes de fabrication habituelles de ces cartes. Ces fonctionnalités supplémentaires sont par exemple celles décrites en relation avec les figures 2 à 5.

L'épaisseur d'un module dépend en pratique de l'épaisseur du circuit intégré du module, qui conditionne la profondeur de la cavité à réaliser et par suite l'épaisseur du support du module dans lequel la cavité est réalisée.

Plus généralement, un module selon l'invention peut être encarté dans tout corps de carte à microcircuit, avec ou sans insert de composants, avec ou sans insert de couches fonctionnelles. En particulier, il permet alors de réduire l'épaisseur de la cavité à réaliser dans le corps de carte.

L'invention ne se limite pas aux exemples de réalisation de carte à microcircuit présentés. En particulier, elle s'applique plus généralement aux différentes formats de cartes conformes à la norme ISO 7816, tels que les formats ID-1 ou ID-000 MMC, ou permettant de former une clef USB, comme par exemple décrit dans la demande FR 2 830 107.

## Revendications

1. Module (M) de carte à microcircuit, destiné à être encarté dans un corps de carte à insert(s), ledit module comportant un support (S), des plages de contact externe (30) sur une face supérieure (T) du support, et des plages de contact interne (40) sur une face inférieure (B) du support qui sont destinées à venir en contact électrique sur des bornes de connexion d'insert(s) du corps de carte, et un circuit intégré sur la face inférieure du support, **caractérisé en ce que** ledit circuit intégré est logé dans l'épaisseur du support (S), dans une cavité ouverte sur ladite face inférieure, les plages de contact interne (40) étant disposées en périphérie de ladite cavité.

2. Module selon la revendication 1, ayant une épaisseur totale mesurée entre les plages de contact externe et les plages de contact interne, épaisseur des plages comprises, supérieure ou égale à la moitié de l'épaisseur normalisée d'une carte à microcircuit, telle que définie dans la norme ISO 7816.

3. Module selon l'une des revendications 1 ou 2, dans lequel le support (S) est réalisé d'une seule pièce (S).

4. Module selon l'une des revendications 1 ou 2, dans lequel ledit support (S) comprend un support supérieur (S1) portant sur une face (T1) les plages de contact externe (30), un support inférieur (S2) portant sur une face les plages de contact interne (40), lesdits supports inférieur et supérieur étant assemblés l'un à l'autre par leur autre face, la cavité (100) étant formée dans l'épaisseur du support inférieur depuis la face portant les plages de contact interne.

5. Module selon la revendication 4, dans lequel ledit support inférieur (S2) a une épaisseur égale à la profondeur de la cavité, ladite cavité correspondant à un estampage réalisé dans l'épaisseur dudit support inférieur.

6. Module selon la revendication 4 ou 5, comprenant des plages de contact intermédiaire (50) disposées à l'interface entre le support supérieur (S1) et le support inférieur (S2), le circuit intégré (200) étant connecté à des plages de contact externes (30) par des plages de contact intermédiaire correspondantes en continuité électrique avec elles, et à des plages de contact interne (40) par des plages de contact intermédiaire correspondantes en continuité électrique avec elles, le circuit intégré et ses connexions étant complètement logés dans la profondeur de la cavité.

7. Module selon l'une des revendications 1 à 6, dans lequel le circuit intégré, est fixé au fond de la cavité par la face du circuit intégré opposée à celle qui porte les plots de connexion du circuit intégré, et connecté par des fils de connexion à des plages de contact (30, 50) du support (S).

8. Module selon la revendication 6, dans lequel le circuit intégré est fixé et connecté au fond de la cavité par la surface portant ses plots de connexion (202), des plages de contact intermédiaire (50) se prolongeant sous chacun des plots de connexion dudit circuit intégré.

9. Module selon la revendication 7 ou 8, comprenant des plots de connexion (202) du circuit intégré (200) connectés à des plages de contact intermédiaire en continuité électrique par des vias métallisés (1 04a) à travers le support supérieur (S1), avec des plages de contact externe et des plots de connexion du circuit intégré connecté à des plages de contact intermédiaire (50) en continuité électrique avec des plages de contact interne (40) par des vias métallisés (1 04b) à travers le support inférieur (S2) du module.

10. Module selon la revendication 7 en combinaison avec la revendication 6, ou selon la revendication 8, dans lequel la cavité est remplie d'un matériau d'enrobage (102) protégeant ledit circuit intégré et ses connexions, ledit module ayant une épaisseur sensiblement constante sous toute sa surface.

11. Carte à microcircuit comprenant un corps de carte (300) et un module (M) à circuit intégré encarté en surface supérieure dudit corps de carte dans une cavité (301) dudit corps de carte, en sorte que des plages de contact externes (3) du module affleurent en surface du corps de carte, **caractérisé en ce que** le module est un module selon l'une quelconque des revendications 1 à 10, la cavité (301) du corps de carte ayant une profondeur supérieure ou égale à la moitié de l'épaisseur dudit corps de carte, et une forme adaptée pour recevoir ledit module.

12. Carte à microcircuit selon la revendication 11, dans laquelle le corps de carte (300) comprend une couche d'un insert (60) dans son épaisseur, ladite couche d'insert comportant au moins un composant et des bornes de connexion (80, 90) correspondantes, la cavité (301) et le module étant tels que lesdites bornes de connexion de la couche d'insert affleurent au fond de ladite cavité (301), et des plages de contact interne du module sont sensiblement alignées en face desdites bornes de connexion, sensiblement sur le même niveau, et en contact électrique avec elles.

13. Carte à microcircuit selon la revendication 11, avec un module (M) selon la revendication 9 en combinaison avec la revendication 6, dans laquelle la cavité du corps de carte a une zone centrale plus profonde pour recevoir une zone centrale (z1) du module comprenant le circuit intégré et ses connexions et une zone périphérique (z2) formant un gradin, sur lequel affleurent les bornes de connexion de la couche d'insert, et sur lequel les plages de contact interne du module reposent au moins en partie.

14. Carte à microcircuit selon la revendication 12, dans lequel le module (M) est un module selon la revendication 9, sensiblement d'égale épaisseur, et la cavité du corps de carte (301) est de profondeur sensiblement égale sur toute sa surface à ladite épaisseur du module.

15. Carte à microcircuit selon l'une quelconque des revendications 12 à 14, dans laquelle la couche d'insert (6) comprend au moins un composant parmi les composants suivants : batterie, module d'affichage, boutons, capteur solaire, cellule biométrique.

16. Carte à microcircuit selon l'une quelconque des revendications 12 à 15, dans laquelle le corps de carte comprend au moins une couche fonctionnelle intermédiaire située dans l'épaisseur du corps de carte entre la surface portant les plages de contact externe du module et ladite couche d'insert (6).

17. Carte à microcircuit selon la revendication 16, dans laquelle une couche fonctionnelle intermédiaire est une couche métallique, ou une couche piézoélectrique.

18. Procédé de fabrication d'une carte à microcircuit, **caractérisé en ce qu'**il comprend une étape de fabrication d'un module à microcircuit (M) comportant une étape de formation de plages de contact externe en surface supérieure et de plages de contact interne en surface inférieure d'un support, et d'une cavité de profondeur au moins égale à l'épaisseur d'un circuit intégré, et de fixation du circuit intégré dans ladite cavité, et une étape de fabrication d'un corps de carte à insert(s), comprenant une étape de formation d'un corps de carte, et d'une cavité dans un corps de carte, de forme adaptée pour recevoir ledit module à microcircuit (M), en sorte que les plages de contact externe du module affleurent en surface dudit corps de carte et que les plages de contact interne du module viennent en contact électrique sur des bornes de connexion d'insert(s) du corps de carte.

## Patentansprüche

1. Chipkartenmodul (M) zum Einführen in ein Kartengehäuse mit einem oder mehreren Einsätzen, wobei das Modul einen Träger (S), externe Kontaktstellen (30) auf einer Oberseite (T) des Trägers und interne Kontaktstellen (40) auf einer Unterseite (B) des Trägers umfasst, die zum elektrischen Kontaktieren von Verbindungsanschlüssen von einem oder mehreren Einsätzen des Kartengehäuses kommen sollen, und eine integrierte Schaltung auf der Unterseite des Trägers, **dadurch gekennzeichnet, dass** die integrierte Schaltung in der Dicke des Trägers (S) in einem offenen Hohlraum auf der Unterseite gelagert ist, wobei die internen Kontaktstellen (40) an der Peripherie des Hohlraums angeordnet sind.

2. Modul nach Anspruch 1 mit einer gemessenen Gesamtdicke zwischen den externen Kontaktstellen und den internen Kontaktstellen, inklusive der Kontaktstellendicken, die gleich oder größer als die Hälfte der Normdicke einer Chipkarte gemäß Definition in der Norm ISO 7816 ist.

3. Modul nach Anspruch 1 oder 2, wobei der Träger (S) aus einem Stück (S) gefertigt ist.

4. Modul nach Anspruch 1 oder 2, wobei der Träger (S) einen auf einer Seite (T1) die externen Kontaktstellen (30) tragenden oberen Träger (S1) und einen auf einer Seite die internen Kontaktstellen (40) tragenden unteren Träger (S2) umfasst, wobei der untere und der obere Träger durch ihre andere Fläche aneinander gefügt sind, wobei der Hohlraum (100) in der Dicke des unteren Trägers von der die internen Kontaktstellen tragenden Seite gebildet wird.

5. Modul nach Anspruch 4, wobei die Dicke des unteren Trägers (S2) gleich der Tiefe des Hohlraums ist, wobei der Hohlraum einer in der Dicke des unteren Trägers erzeugten Prägung entspricht.

6. Modul nach Anspruch 4 oder 5, das Zwischenkontaktstellen (50) umfasst, die auf der Grenzfläche zwischen dem oberen Träger (S1) und dem unteren Träger (S2) angeordnet sind, wobei die integrierte Schaltung (200) mit externen Kontaktstellen (30) durch entsprechende Zwischenkontaktstellen in elektrischer Kontinuität damit und mit internen Kontaktstellen (40) durch entsprechende Zwischenkontaktstellen in elektrischer Kontinuität damit verbunden ist, wobei sich die integrierte Schaltung und ihre Anschlüsse vollständig in der Tiefe des Hohlraums befinden.

7. Modul nach einem der Ansprüche 1 bis 6, wobei die integrierte Schaltung am Boden des Hohlraums durch die Seite der integrierten Schaltung befestigt ist, die der Seite gegenüberliegt, die die Anschlusskontakte der integrierten Schaltung trägt, und über Verbindungsdrähte mit Kontaktstellen (30, 50) des Trägers (S) verbunden ist.

8. Modul nach Anspruch 6, wobei die integrierte Schaltung am Boden des Hohlraums durch die Fläche befestigt und verbunden ist, die ihre Anschlusskontakte (202) trägt, wobei Zwischenkontaktstellen (50) unter jedem der Anschlusskontakte der integrierten Schaltung verlaufen.

9. Modul nach Anspruch 7 oder 8, das Anschlusskontakte (202) der integrierten Schaltung (200) umfasst, die mit Zwischenkontaktstellen in elektrischer Kontinuität über metallisierte Durchkontaktierungen (104a) durch den oberen Träger (S1) verbunden sind, wobei externe Kontaktstellen und Anschlusskontakte der integrierten Schaltung mit Zwischenkontaktstellen (50) in elektrischer Kontinuität mit internen Kontaktstellen (40) über metallisierte Durchkontaktierungen (104b) durch den unteren Träger (S2) des Moduls verbunden sind.

10. Modul nach Anspruch 7, in Kombination mit Anspruch 6, oder nach Anspruch 8, wobei der Hohlraum mit einem Beschichtungsmaterial (102) gefüllt ist, das die integrierte Schaltung und ihre Anschlüsse schützt, wobei die Dicke des Moduls über dessen gesamte Oberfläche im Wesentlichen konstant ist.

11. Chipkarte, die ein Chipgehäuse (300) und ein Modul (M) mit einer integrierten Schaltung umfasst, die in die Oberseite des Kartengehäuses in einem Hohlraum (301) des Chipgehäuses eingeschlossen ist, so dass externe Kontaktstellen (3) des Moduls mit der Oberfläche des Kartengehäuses bündig sind, **dadurch gekennzeichnet, dass** das Modul ein Modul nach einem der Ansprüche 1 bis 10 ist, wobei die Tiefe des Hohlraums (301) des Kartengehäuses gleich oder größer als die Hälfte der Dicke des Kartengehäuses ist, und der Hohlraum zur Aufnahme des Moduls geformt ist.

12. Chipkarte nach Anspruch 11, wobei das Kartengehäuse (300) eine Schicht eines Einsatzes (60) in seiner Dicke hat, wobei die Einsatzschicht wenigstens eine Komponente und entsprechende Verbindungsanschlüsse (80, 90) aufweist, wobei der Hohlraum (301) und das Modul derart sind, dass die Verbindungsanschlüsse der Einsatzschicht mit dem Boden des Hohlraums (301) bündig sind, und interne Kontaktstellen des Moduls im Wesentlichen gegenüber den Verbindungsanschlüssen ausgerichtet sind, im Wesentlichen in derselben Ebene und in elektrischem Kontakt damit.

13. Chipkarte nach Anspruch 11 mit einem Modul (M) nach Anspruch 9 in Kombination mit Anspruch 6, wobei der Hohlraum des Kartengehäuses eine tiefere zentrale Zone zur Aufnahme einer zentralen Zone (z1) des Moduls hat, das die integrierte Schaltung und seine Anschlüsse umfasst, und eine periphere Zone (z2) hat, die eine Stufe bildet, auf der die Verbindungsanschlüsse der Einsatzschicht bündig sind und auf der die internen Kontaktstellen des Moduls wenigstens teilweise ruhen.

14. Chipkarte nach Anspruch 12, wobei das Modul (M) ein Modul nach Anspruch 9 von im Wesentlichen gleicher Dicke ist und die Tiefe des Hohlraums des Kartengehäuses (301) im Wesentlichen über seine gesamte Oberfläche gleich der Dicke des Moduls ist.

15. Chipkarte nach einem der Ansprüche 12 bis 14, wobei die Einsatzschicht (6) wenigstens eine Komponente aus den folgenden Komponenten umfasst: Batterie, Anzeigemodul, Tasten, Solarsensor, biometrische Zelle.

16. Chipkarte nach einem der Ansprüche 12 bis 15, wobei das Kartengehäuse wenigstens eine Zwischenfunktionsschicht umfasst, die sich in der Dicke des Kartengehäuses zwischen der die externen Kontaktstellen des Moduls tragenden Oberfläche und der Einsatzschicht (6) befindet.

17. Chipkarte nach Anspruch 16, wobei eine Zwischenfunktionsschicht eine metallische Schicht oder eine piezoelektrische Schicht ist.

18. Verfahren zur Herstellung einer Chipkarte, **dadurch gekennzeichnet, dass** es einen Schritt des Herstellens eines Chipmoduls (M) umfasst, der Folgendes beinhaltet: einen Schritt des Bildens von externen Kontaktstellen auf der Oberseite und internen Kontaktstellen auf der Unterseite eines Trägers und eines Hohlraums, der wenigstens so tief ist wie die Dicke einer integrierten Schaltung, und des Befestigens der integrierten Schaltung in dem Hohlraum, und einen Schritt des Herstellens eines Kartengehäuses mit einem oder mehreren Einsätzen, der einen Schritt des Bildens eines Chipgehäuses und eines Hohlraums mit einer geeigneten Form zum Aufnehmen des Chipmoduls (M) in einem Kartengehäuse beinhaltet, so dass die externen Kontaktstellen des Moduls mit der Oberfläche des Kartengehäuses bündig sind und so dass die internen Kontaktstellen des Moduls in elektrischen Kontakt mit Verbindungsanschlüssen von einem oder mehreren Einsätzen des Kartengehäuses kommen.

## Claims

1. A chip card module (M) intended to be inserted in a chip body with insert(s), said module comprising a support (S), external contact pads (30) on an upper face (T) of said support, and internal contact pads (40) on an inner face (B) of said support that are intended to come into electric contact with connection terminals of one or more insert(s) of said chip body, and an integrated circuit on the lower face of said support, **characterised in that** said integrated circuit is housed in the thickness of said support (S), in an open cavity on said lower face, said internal contact pads (40) being disposed on the periphery of said cavity.

2. The module according to claim 1, with a total measured thickness between said external contact pads and said internal contact pads, all pad thicknesses combined, that is greater than or equal to half the standardised thickness of a chip card, as defined in standard ISO 7816.

3. The module according to either claim 1 or 2, wherein said support (S) is produced as a single part (S).

4. The module according to either claim 1 or 2, wherein said support (S) comprises an upper support (S1) supporting said external contact pads (30) on a face (T1), a lower support (S2) supporting said internal contact pads (40) on a face, said lower and upper supports being assembled together via their other face, said cavity (100) being formed in the thickness of said lower support from the face supporting said internal contact pads.

5. The module according to claim 4, wherein the thickness of said lower support (S2) is equal to the depth of said cavity, said cavity corresponding to a stamp produced in the thickness of said lower support.

6. The module according to claim 4 or 5, comprising intermediate contact pads (50) disposed on the interface between said upper support (S1) and said lower support (S2), said integrated circuit (200) being connected to external contact pads (30) via corresponding intermediate contact pads in electrical continuity therewith and to internal contact pads (40) via corresponding intermediate contact pads in electrical continuity therewith, said integrated circuit and its connections being fully housed in the depth of said cavity.

7. The module according to any one of claims 1 to 6, wherein said integrated circuit is fixed to the bottom of said cavity via the face of said integrated circuit that is opposite the face that supports the connection studs of said integrated circuit and is connected via connection wires to contact pads (30, 50) of said support (S).

8. The module according to claim 6, wherein said integrated circuit is fixed and connected to the bottom of said cavity via the surface supporting its connection studs (202), with intermediate contact pads (50) extending under each connection stud of said integrated circuit.

9. The module according to claim 7 or 8, comprising connection studs (202) of said integrated circuit (200) connected to intermediate connection pads in electrical continuity via metal vias (104a) through said upper support (S1), with external contact pads and connection studs of said integrated circuit being connected to intermediate contact pads (50) in electrical continuity with internal contact pads (40) via metal vias (104b) through said lower support (S2) of said module.

10. The module according to claim 7 in combination with claim 6, or according to claim 8, wherein said cavity is filled with a coating material (102) protecting said integrated circuit and its connections, the thickness of said module being substantially constant under its entire surface area.

11. A chip card comprising a chip body (300) and a module (M) with an integrated circuit inserted in the upper surface of said chip body in a cavity (301) of said chip body so that external contact pads (3) of said module are flush with the surface of said chip body, **characterised in that** said module is a module according to any one of claims 1 to 10, the depth of said cavity (301) of said chip body being greater than or equal to half the thickness of said chip body and being shaped to receive said module.

12. The chip card according to claim 11, wherein said chip body (300) comprises a layer with an insert (60) in its thickness, said insert layer comprising at least one component and corresponding connection terminals (80, 90), said cavity (301) and said module being such that said connection terminals of said insert layer are flush with the bottom of said cavity (301), and internal contact pads of said module are substantially aligned opposite said connection terminals, substantially on the same level, and in electric contact therewith.

13. The chip card according to claim 11, with a module (M) according to claim 9 in combination with claim 6, wherein said cavity of said chip body has a deeper central zone for receiving a central zone (z1) of said module comprising said integrated circuit and its connections and has a peripheral zone (z2) forming a step, on which said connection terminals of said insert layer are flush and on which said internal contact pads of said module are at least partly supported.

14. The chip card according to claim 12, wherein said module (M) is a module according to claim 9, of substantially equal thickness, and the depth of said cavity of said chip body (301) is substantially equal, over its entire surface area, to said thickness of said module.

15. The chip card according to any one of claims 12 to 14, wherein said insert layer (6) comprises at least one component from among the following components: battery, display module, buttons, solar sensor, biometric cell.

16. The chip card according to any one of claims 12 to 15, wherein said chip body comprises at least one intermediate functional layer located in the thickness of said chip body between the surface supporting said external contact pads of said module and said insert layer (6).

17. The chip card according to claim 16, wherein an intermediate functional layer is a metal layer or a piezoelectric layer.

18. A method for manufacturing a chip card, **characterised in that** it comprises a step of manufacturing a chip module (M), comprising a step of forming external contact pads on the upper surface and internal contact pads on the lower surface of a support and a cavity, which is at least as deep as the thickness of an integrated circuit, and of fixing said integrated circuit inside said cavity, and a step of manufacturing a chip body with one or more insert(s), comprising a step of forming a chip body and a cavity, of suitable shape for receiving said chip module (M), inside a chip body so that said external contact pads of said module are flush with the surface of said chip body and so that said internal contact pads of said module come into electric contact with connection terminals of one or more insert(s) of said chip body.
